# EUROPEAN PATENT APPLICATION

(11) **EP 4 523 952 A1**
(43) Date of publication of application: **19.03.2025**
(21) Application number: 24200000.8
(22) Date of filing: 12.09.2024
(51) Int. Cl.: B60L 53/14, B60L 53/30, B60L 53/31, B60L 53/67

(54) **GROUP ELECTRIC VEHICLE SUPPLY EQUIPMENT (EVSE) SYSTEMS**

(30) Priority: 14.09.2023 US 202318368474
(71) Applicant: Schneider Electric USA, Inc., Andover, MA 01810 (US)
(72) Inventor: JEFFERIES, Kevin Michael, 27606 Raleigh, NC (US); FREEMAN, Alan Edward, 27604 Raleigh, NC (US); EDWARDS, Benjamin Wilson, 27571 Rolesville, NC (US); FILIPPENKO, Konstantin Alexander, 27513 Cary, NC (US); FURNARI, Matthew Paul, 27614 Raleigh, NC (US); WHITE, Matthew Lee, 27511 Cary, NC (US)
(74) Representative: Manitz Finsterwald Patent- und Rechtsanwaltspartnerschaft mbB

(57) **Abstract**

An electric vehicle (EV) charging system can include a plurality of charging terminals, each charging terminal comprising a charging cable configured to connect to an electric vehicle. The system can include an electrical equipment assembly physically separated from the plurality of charging terminals. The assembly can include a plurality of electric vehicle supply equipment (EVSE) loads, each EVSE load configured to supply power to a respective charging terminal to provide a charge current to an EV connected to the cable of the charging terminal. A main breaker can be connected to the plurality of EVSE loads configured to supply power to the plurality of EVSE loads and to provide fault protection to the plurality of EVSE loads to provide protection to each charging terminal. In certain embodiments, the main breaker is at least partially solid state.

## Description

### FIELD

This disclosure relates to group electric vehicle supply equipment (EVSE) systems.

### BACKGROUND

Systems having multiple electric vehicle chargers can have multiple branch circuits connecting to electric vehicle supply equipment (EVSE). Each EVSE has the logic to control charging, and ultimately the charging cable is electrically connected to each EVSE when charging. Traditional charging stations (e.g., pedestals or wall installations) accessible to the public contain expensive electronics components and are therefore subject to theft and/or damage because such charging stations are located in unprotected locations.

Conventional methods and systems have generally been considered satisfactory for their intended purpose. However, there is still a need in the art for improvements. The present disclosure provides a solution for this need.

### SUMMARY

An electric vehicle (EV) charging system can include a plurality of charging terminals, each charging terminal comprising a charging cable configured to connect to an electric vehicle. The system can include an electrical equipment assembly physically separated from the plurality of charging terminals. The assembly can include a plurality of electric vehicle supply equipment (EVSE) loads, each EVSE load configured to supply power to a respective charging terminal to provide a charge current to an EV connected to the cable of the charging terminal. A main breaker can be connected to the plurality of EVSE loads configured to supply power to the plurality of EVSE loads and to provide fault protection to the plurality of EVSE loads to provide protection to each charging terminal. In certain embodiments, the main breaker is at least partially solid state.

In certain embodiments, the main breaker is a hybrid solid state mechanical breaker. In certain embodiments, the main breaker is a solid state breaker.

In certain embodiments, each charging terminal can include a housing and terminal block inside the housing connected between a respective EVSE load and the charging cable. In certain embodiments, the terminal block does not include local protection circuitry and is protected against fault by only a respective EVSE load and the main breaker in the electrical equipment assembly.

In certain embodiments, the terminal block can include a switch configured to carry suitable current from the electrical equipment assembly to the charging cable. In certain embodiments, the switch is a relay and/or a definite purpose contactor.

In certain embodiments, each charging terminal can include no other circuitry or switching components. In certain embodiments, each charging terminal can be disposed in an unsecured location.

In certain embodiments, the electrical equipment assembly can be disposed in a secured location and/or housing structure. Each charging terminal can be connected to a respective EVSE load via a connecting conductor.

In certain embodiments, each EVSE load can be configured to determine when there is fault between the respective EVSE load and a respective charging terminal, and to shut off in a fault condition. In certain embodiments, the main breaker can be configured to trip in the fault condition to thereby shutdown current to the plurality of EVSE loads and to clear the fault condition. In certain embodiments, each EVSE load can be configured to communicate a fault signal to the main breaker to indicate the fault when in the fault condition. The main breaker can be configured to turn on to allow other non-faulted EVSE loads to operate thereby allowing one or more charging terminals associated with the non-faulted EVSE loads to be operational. In certain embodiments, the main breaker can be configured such that if no fault signal is received from one or more EVSE loads, the main breaker remains off to prevent current to all of the EVSE loads.

In certain embodiments, the fault condition can be a ground fault or an overcurrent beyond a threshold. In certain embodiments, the main breaker can be the only breaker for the plurality of EVSE loads and charging terminals.

In accordance with at least one aspect of this disclosure, an electrical equipment assembly for electric vehicle charging can be physically separated from a plurality of charging terminals. The assembly can be or include any suitable embodiment of an electrical equipment assembly as disclosed herein.

These and other features of the embodiments of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:
Fig. 1 is a schematic diagram of an embodiment of a system in accordance with this disclosure; and
Fig. 2 us a schematic diagram of an embodiment of a system in accordance with this disclosure.

### DETAILED DESCRIPTION

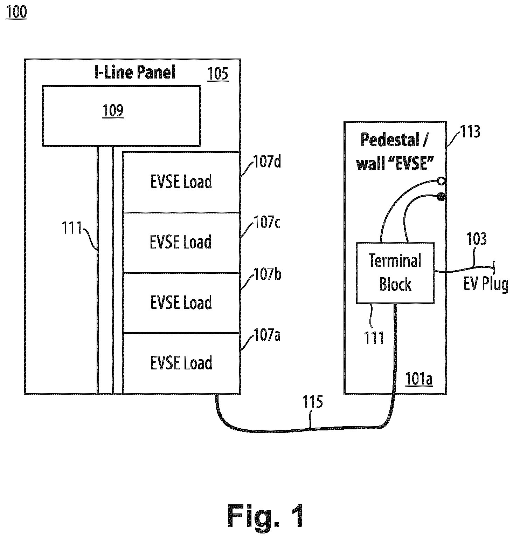

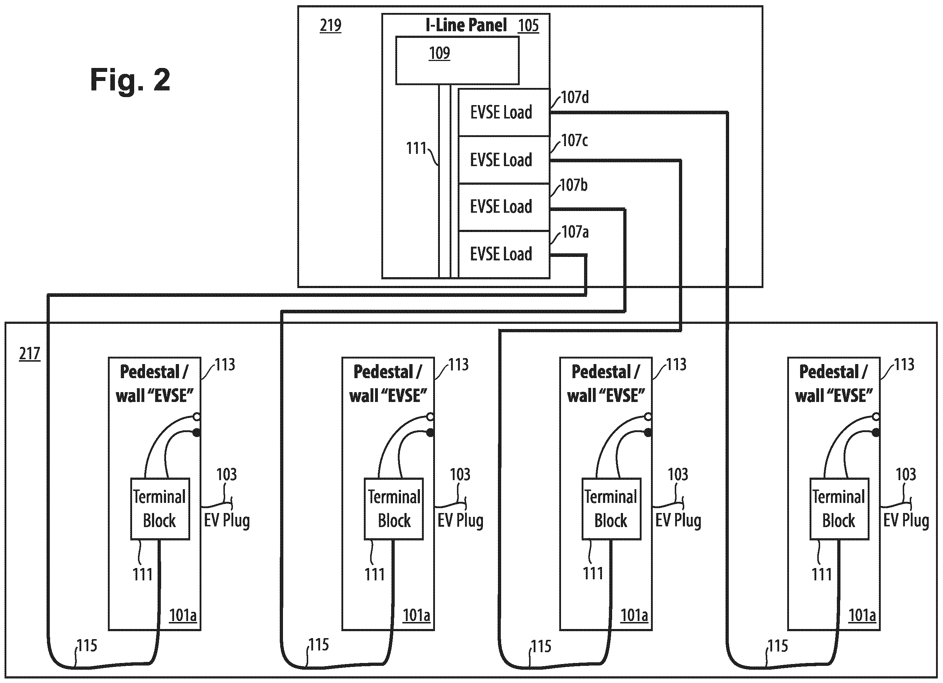

Reference will now be made to the drawings wherein like reference numerals identify similar structural features or aspects of the subject disclosure. For purposes of explanation and illustration, and not limitation, an illustrative view of an embodiment of a system in accordance with the disclosure is shown in Fig. 1 and is designated generally by reference character 100. Other embodiments and/or aspects of this disclosure are shown in Fig. 2. Certain embodiments can be used to remove expensive components from charging terminals (e.g., ground fault/short circuit protection circuitry) and into a protected area, for example. Any other suitable use is contemplated herein.

Referring to Figs. 1 and 2, an electric vehicle (EV) charging system 100 can include a plurality of charging terminals 101a, 101b, 101c, 101d (a single charging terminal 101a shown for clarity in Fig. 1), each charging terminal comprising a charging cable 103 configured to connect to an electric vehicle. The system 100 can include an electrical equipment assembly 105 physically separated (e.g., in a separate housing and/or physically spaced) from the plurality of charging terminals 101a, b, c, d.

The assembly 105 can include a plurality of electric vehicle supply equipment (EVSE) loads 107a, b, c, d (e.g., two or more). Each EVSE load 107a, b, c, d can be configured to supply power to a respective charging terminal 101a, b, c, d to provide a charge current to an EV connected to the cable 103 of the charging terminal 101a, b, c, d. Each EVSE load 107a, b, c, d can include a relay or contactor circuitry (e.g., a PCBA). Each EVSE load 107a, b, c, d can include a charge circuit interrupter device (CCID) of any suitable trip threshold (e.g., CCID20 for 20mA ground fault threshold). Each EVSE load 107a, b, c, d can be configured to provide a control signal (SC) and/or a control pilot (CP) signal. Each EVSE load 107a, b, c, d can include a logic module to tell when there is ground fault or overcurrent beyond a maximum threshold for vehicle, to output a fault signal in such a fault condition, and to shut of off in such a fault condition.

The system 100 can include a main breaker 109 that can be connected to the plurality of EVSE loads 107a, b, c, d (e.g., via a common bus bar 111) configured to supply power to the plurality of EVSE loads 107a, b, c, d and to provide fault protection to the plurality of EVSE loads 107a, b, c, d to provide protection to each charging terminal 101a, b, c, d. In certain embodiments, the main breaker 109 is at least partially solid state. In certain embodiments, the main breaker 109 is a hybrid solid state mechanical breaker. For example, the main breaker 109 can include hybrid switching technology and can provide current limiting and energy management control.

In certain embodiments, the main breaker 109 is a purely solid state breaker. Such embodiments may include additional cooling systems to further cool the main breaker 109 and/or related solid state circuitry. Having the main breaker 109 be at least partially solid state can provide suitably fast response time (e.g., about 20ms or less) in a non-local location to each charging terminal 101a, b, c, d to provide desired protection (e.g., which can remove the need to have any expensive electronics in the charging terminals 101a, b, c, d).

In certain embodiments, each charging terminal 101a, b, c, d can include a housing 113 and terminal block 115 inside the housing 113 connected between a respective EVSE load 107a and the charging cable 103. In certain embodiments, the terminal block 111 does not include local protection circuitry and is protected against fault by only a respective EVSE load 107a and the main breaker 109 in the electrical equipment assembly 105. For example, in certain embodiments, the terminal block 111 can include a switch (not shown) configured to carry suitable current from the electrical equipment assembly 105 to the charging cable 103. In certain embodiments, the switch (not shown) is a relay and/or a definite purpose (DP) contactor. Such a switch (not shown) can have a response time that is too slow to provide suitable protection against a ground fault or short circuit (e.g., greater than about 20ms). In certain embodiments, each charging terminal 101a, b, c, d can include no other circuitry or switching components.

In certain embodiments, e.g., as show in Fig. 2, each charging terminal 101a, b, c, d can be disposed in an unsecured location 217 (e.g., accessible to EV drivers at a parking space for accessing charging via the charging cable 103). In certain embodiments, e.g., as shown in Fig. 2, the electrical equipment assembly 105 can be disposed in a secured location and/or housing structure 219 (e.g., within a protective housing and/or within a gated location positioned further from a parking space than each charging terminal 101a, b, c, d). Each charging terminal 101a, b, c, d can be connected to a respective EVSE load 107a, b, c, d via a connecting conductor 115 (e.g., buried underground or otherwise protected/hidden). The connecting conductor 115 can include power wiring (e.g., 8/2 romex) and/or an information/low power carrier (e.g., an RJ450 cable).

In certain embodiments, each EVSE load 107a, b, c, d can be configured to determine when there is fault between the respective EVSE load 107a, b, c, d and a respective charging terminal 101a, b, c, d (e.g., EVSE load 107a can determine whether there is a fault at the charging terminal 101a and/or charging cable/connector), and to shut off in a fault condition. In certain embodiments, the main breaker 109 can be configured to trip in the fault condition to thereby shutdown current to the plurality of EVSE loads 107a, b, c, d and to clear the fault condition. In certain embodiments, each EVSE load 107a, b, c, d can be configured to communicate a fault signal to the main breaker 105 (e.g., if that EVSE load is associated with a fault) to indicate the fault when in the fault condition (e.g., during or after a fault). For example, if there is a ground fault somewhere on the charging terminal 101a circuit associated with the EVSE load 107a, the EVSE load 107a can determine that a fault has occurred (e.g., before, during, or after main breaker 109 trips). The main breaker 109 can be configured to turn on to allow other non-faulted EVSE loads (e.g., EVSE loads 107b, c, d in the above example) to operate thereby allowing one or more charging terminals (charging terminals 101b, c, d in the above example) associated with the non-faulted EVSE loads (e.g., EVSE loads 107b, c, d in the above example) to be operational. In certain embodiments, the speed of the main breaker 109 to turn back on is dependent on speed of each EVSE logic module to determine whether there is a fault and a time to open (e.g., about 50ms in certain embodiments).

In certain embodiments, the main breaker 109 can be configured such that if no fault signal is received from one or more EVSE loads (any one or plurality of EVSE loads 107a, b, c, d), the main breaker 109 remains off to prevent current to all of the EVSE loads 107a, b, c, d. In this case, there may be a faulty EVSE load and/or other undetectable issue on one or more of the branches of the system 100 and the main breaker 109 can stay off to prevent damage or injury until manually reset by a technician.

In certain embodiments, the fault condition can be a ground fault or an overcurrent beyond a threshold. In certain embodiments, the main breaker 109 can be the only breaker for the plurality of EVSE loads 107a, b, c, d and charging terminals 101a, b, c, d (e.g., as shown in Figs. 1 and 2).

In accordance with at least one aspect of this disclosure, an electrical equipment assembly 105 for electric vehicle charging can be physically separated from a plurality of charging terminals 101a, b, c, d. The assembly 105 can be or include any suitable embodiment of an electrical equipment assembly 105 as described above, for example.

Embodiments can utilize a hybrid solid state breaker or completely solid state breaker which trips faster and does well communicating with downstream devices compared to purely mechanical breakers, for example. In traditional systems, each EVSE load has its own breaker, but certain embodiments can utilize a single at least partially solid state breaker device to protect multiple EVSE loads. In certain embodiments, there is no individual short circuit protection in the charging terminals (e.g., a pedestal or wall mount), nor is there a high speed contactor which is more expensive than cheaper, basic contactors. Embodiments can reduce the cost of the overall charging system as well as reduce the amount of components in unprotected locations, reducing risk of damage or theft. Embodiments include components positioned and selected to be suitably fast to protect against short circuit/ground fault without requiring fast contactors or expensive circuitry in the charging terminals.

Certain embodiments can include an architecture for group EVSE installations that have EVSE "panelization" and utilize a techno brick (hybrid switch) and "total coordination" to optimize system cost. Certain embodiments can include a main breaker (for the entire EVSE group) can include a hybrid switch and current limiter, and electronics for energy management system control as well as control pilot output/command to loads. Certain embodiments can include an EVSE load block (one or more EVSE loads as described above) in a panel having low-cost switching (e.g., a relay or DP contactor), load CCID20 detection, a proximity circuit, and a control pilot output.

Embodiments can include a group EVSE installation architecture which comprises a hybrid switch main breaker that provides group short circuit and ground current breaking capability, monitors group-level energy consumption against a group-level energy limit, and provides a command signal to EVSE load function blocks to decrease EV charging rates, and which also has EVSE load function blocks that provide load-level isolation capability, detect load level faults (short circuit, CCID20 ground current) and solicit protection from the group main breaker. Embodiments can also generate an EV control pilot output based on command signal from main breaker and manage EV control pilot interaction.

Embodiments can provide a cost-optimized architecture that is designed intentionally for multi-EVSE installation. Embodiments can eliminate unnecessary redundancies. Embodiments can obviate the need for many expensive components (e.g., networked EVSE boxes, power meters, network switches) versus traditional systems.

Embodiments (e.g., main breakers, EVSE loads) can include any suitable computer hardware and/or software module(s) to perform any suitable function (e.g., as disclosed herein). As will be appreciated by those skilled in the art, aspects of the present disclosure may be embodied as a system, method or computer program product. Accordingly, aspects of this disclosure may take the form of an entirely hardware embodiment, an entirely software embodiment (including firmware, resident software, micro-code, etc.), or an embodiment combining software and hardware aspects, all possibilities of which can be referred to herein as a "circuit," "module," or "system." A "circuit," "module," or "system" can include one or more portions of one or more separate physical hardware and/or software components that can together perform the disclosed function of the "circuit," "module," or "system", or a "circuit," "module," or "system" can be a single self-contained unit (e.g., of hardware and/or software). Furthermore, aspects of this disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber cable, RF, etc., or any suitable combination of the foregoing.

Computer program code for carrying out operations for aspects of this disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of this disclosure may be described above with reference to flowchart illustrations and/or block diagrams of methods, apparatus (systems) and computer program products according to embodiments of this disclosure. It will be understood that each block of any flowchart illustrations and/or block diagrams, and combinations of blocks in any flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in any flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified herein.

Those having ordinary skill in the art understand that any numerical values disclosed herein can be exact values or can be values within a range. Further, any terms of approximation (e.g., "about", "approximately", "around") used in this disclosure can mean the stated value within a range. For example, in certain embodiments, the range can be within (plus or minus) 20%, or within 10%, or within 5%, or within 2%, or within any other suitable percentage or number as appreciated by those having ordinary skill in the art (e.g., for known tolerance limits or error ranges).

The articles "a", "an", and "the" as used herein and in the appended claims are used herein to refer to one or to more than one (i.e., to at least one) of the grammatical object of the article unless the context clearly indicates otherwise. By way of example, "an element" means one element or more than one element.

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of."

Any suitable combination(s) of any disclosed embodiments and/or any suitable portion(s) thereof are contemplated herein as appreciated by those having ordinary skill in the art in view of this disclosure.

The embodiments of the present disclosure, as described above and shown in the drawings, provide for improvement in the art to which they pertain. While the subject disclosure includes reference to certain embodiments, those skilled in the art will readily appreciate that changes and/or modifications may be made thereto without departing from the spirit and scope of the subject disclosure.

## Claims

1. An electric vehicle (EV) charging system, comprising:
a plurality of charging terminals, each charging terminal comprising a charging cable configured to connect to an electric vehicle; and
an electrical equipment assembly physically separated from the plurality of charging terminals, the assembly comprising:
a plurality of electric vehicle supply equipment (EVSE) loads, each EVSE load configured to supply power to a respective charging terminal to provide a charge current to an EV connected to the cable of the charging terminal; and
a main breaker connected to the plurality of EVSE loads configured to supply power to the plurality of EVSE loads and to provide fault protection to the plurality of EVSE loads to provide protection to each charging terminal, wherein the main breaker is at least partially solid state.

2. The system of claim 1, wherein the main breaker is a hybrid solid state mechanical breaker.

3. The system of claim 1, wherein the main breaker is a solid state breaker.

4. The system of claim 1, wherein each charging terminal includes a housing and terminal block inside the housing connected between a respective EVSE load and the charging cable.

5. The system of claim 4, wherein the terminal block does not include local protection circuitry and is protected against fault by only a respective EVSE load and the main breaker in the electrical equipment assembly.

6. The system of claim 5, wherein the terminal block includes a switch configured to carry suitable current from the electrical equipment assembly to the charging cable.

7. The system of claim 6, wherein the switch is a relay and/or a definite purpose contactor.

8. The system of claim 5, wherein each charging terminal includes no other circuitry or switching components.

9. The system of claim 1, wherein each charging terminal is disposed in an unsecured location.

10. The system of claim 9, wherein the electrical equipment assembly is disposed in a secured location and/or housing structure.

11. The system of claim 10, wherein each charging terminal is connected to a respective EVSE load via a connecting conductor.

12. The system of claim 1, wherein each EVSE load is configured to determine when there is fault between the respective EVSE load and a respective charging terminal, and to shut off in a fault condition.

13. The system of claim 12, wherein the main breaker is configured to trip in the fault condition to thereby shutdown current to the plurality of EVSE loads and to clear the fault condition.

14. The system of claim 13, wherein each EVSE load is configured to communicate a fault signal to the main breaker to indicate the fault when in the fault condition, wherein the main breaker is configured to turn on to allow other non-faulted EVSE loads to operate thereby allowing one or more charging terminals associated with the non-faulted EVSE loads to be operational.

15. The system of claim 14, wherein the main breaker is configured such that if no fault signal is received from one or more EVSE loads, the main breaker remains off to prevent current to all of the EVSE loads.

16. The system of claim 13, wherein the fault condition is a ground fault or an overcurrent beyond a threshold.

17. The system of claim 1, wherein the main breaker is the only breaker for the plurality of EVSE loads and charging terminals.

18. An electrical equipment assembly for electric vehicle charging, the assembly physically separated from a plurality of charging terminals, the assembly comprising:
a plurality of electric vehicle supply equipment (EVSE) loads, each EVSE load configured to supply power to a respective charging terminal to provide a charge current to an EV connected to the cable of the charging terminal; and
a main breaker connected to the plurality of EVSE loads configured to supply power to the plurality of EVSE loads and to provide fault protection to the plurality of EVSE loads to provide protection to each charging terminal, wherein the main breaker is at least partially solid state, wherein the main breaker is the only breaker for the plurality of EVSE loads.

19. The assembly of claim 18, wherein each EVSE load is configured to determine when there is fault between the respective EVSE load and a respective charging terminal, and to shut off in a fault condition, and wherein the main breaker is configured to trip in the fault condition to thereby shutdown current to the plurality of EVSE loads and to clear the fault condition.

20. The assembly of claim 19, wherein each EVSE load is configured to communicate a fault signal to the main breaker to indicate the fault when in the fault condition, wherein the main breaker is configured to turn on to allow other non-faulted EVSE loads to operate thereby allowing one or more charging terminals associated with the non-faulted EVSE loads to be operational, wherein the main breaker is configured such that if no fault signal is received from one or more EVSE loads, the main breaker remains off to prevent current to all of the EVSE loads.
